# EUROPEAN PATENT APPLICATION

(11) **EP 4 625 475 A1**
(43) Date of publication of application: **01.10.2025**
(21) Application number: 25166725.9
(22) Date of filing: 27.03.2025
(51) Int. Cl.: H01L 21/311

(54) **PROCESSING METHOD, METHOD OF MANUFACTURING SEMICONDUCTOR DEVICE, PROGRAM AND PROCESSING APPARATUS**

(30) Priority: 28.03.2024 JP 2024054781
(71) Applicant: Kokusai Electric Corp., Tokyo 1010045 (JP)
(72) Inventor: MIZUNO, Norikazu, Toyama-shi, 939-2393 (JP); OGAWA, Arito, Toyama-shi, 939-2393 (JP)
(74) Representative: Verscht, Thomas Kurt Albert

(57) **Abstract**

It is possible to possible to selectively etch a specific region. There is provided a technique that includes: (a) adsorbing an inhibitor onto a second surface of an object by supplying the inhibitor to the object, wherein the object is provided with a first surface and the second surface; (b) supplying a first halogen element-containing gas to the first surface; (c) supplying a second halogen element-containing gas to the first surface; and (d) removing at least a part of the first surface by performing (b) and (c) N times.

## Description

### [Technical Field]

The present disclosure relates to a processing method, a method of manufacturing a semiconductor device, a program and a processing apparatus.

### [Related Art]

As a part of a substrate processing (that is, a manufacturing process of a semiconductor device), a film may be etched by performing a cycle of supplying different types of gases a predetermined number of times (for example, see Patent Document 1).

### [Related Art Document]

### [Patent Document]

Patent Document 1: Japanese Patent Laid-Open No. 2021-158142.

### [Disclosure]

### [Technical Problem]

However, it may be difficult to selectively etch a certain region.

According to the present disclosure, there is provided a technique capable of selectively etching a specific region.

### [Technical Solution]

According to an embodiment of the present disclosure, there is provided a technique that includes: (a) adsorbing an inhibitor onto a second surface of an object by supplying the inhibitor to the object, wherein the object is provided with a first surface and the second surface; (b) supplying a first halogen element-containing gas to the first surface; (c) supplying a second halogen element-containing gas to the first surface; and (d) removing at least a part of the first surface by performing (b) and (c) N times.

### [Advantageous Effects]

According to some embodiments of the present disclosure, it is possible to selectively etch a specific region.

### [Brief Description of Drawings]

FIG. 1 is a diagram schematically illustrating a vertical cross-section of a substrate processing apparatus according to one or more embodiments of the present disclosure.
FIG. 2 is a block diagram schematically illustrating a configuration of a controller and related components of the substrate processing apparatus according to the embodiments of the present disclosure.
FIG. 3 is a flow chart schematically illustrating a substrate processing according to the embodiments of the present disclosure.
FIG. 4A is a diagram schematically illustrating a substrate with a first film 300 and a second film 400 formed on a surface thereof, FIG. 4B is a diagram schematically illustrating the substrate with an inhibitor film 500 formed on the second film 400, and FIG. 4C is a diagram schematically illustrating the substrate after an etching process is performed on the substrate with the inhibitor film 500 formed on the second film 400.
FIG. 5A is a diagram schematically illustrating a surface of an aluminum oxide film before an inhibitor is supplied, FIG. 5B is a diagram schematically illustrating the surface of the aluminum oxide film after the inhibitor is supplied, FIG. 5C is a diagram schematically illustrating a surface of a titanium nitride film before the inhibitor is supplied, and FIG. 5D is a diagram schematically illustrating the surface of the titanium nitride film after the inhibitor is supplied.
FIG. 6A is a diagram schematically illustrating the substrate with the first film 300 and the second film 400 formed on the surface thereof, and FIG. 6B is a diagram schematically illustrating the substrate after the etching process is performed on the substrate with the first film 300 and the second film 400 formed on the surface thereof.
FIG. 7 is a diagram schematically illustrating a comparison of etching rates of the titanium nitride film, the aluminum oxide film, a silicon nitride film, a silicon oxide film and a silicon film.
FIG. 8 is a flow chart schematically illustrating a substrate processing according to a modified example.

### [Detailed Description]

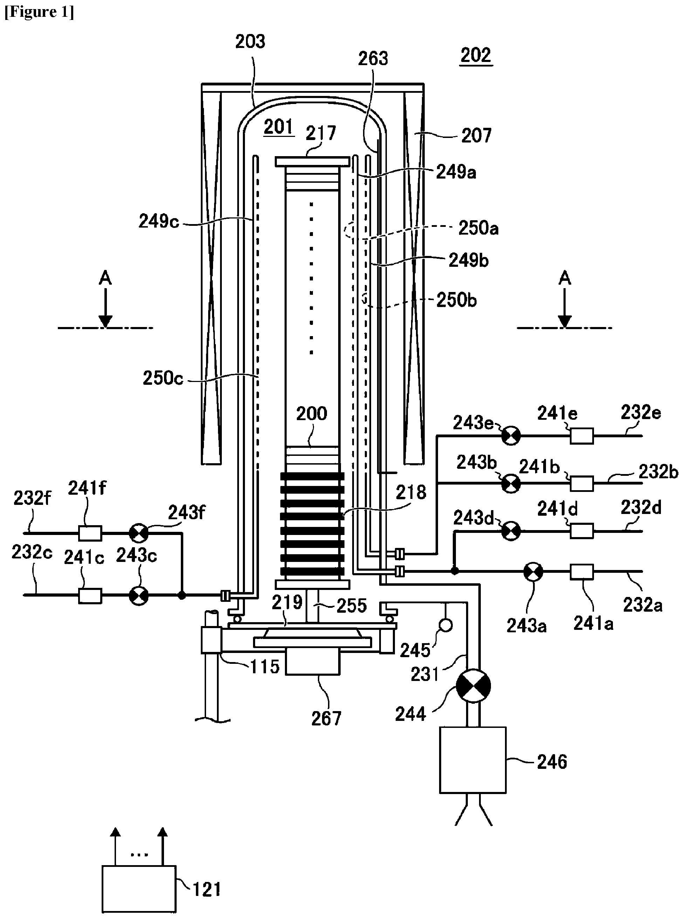

Hereinafter, one or more embodiments (also simply referred to as "embodiments") according to the technique of the present disclosure will be described mainly with reference to FIGS. 1 to 8. Further, the drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match. In addition, the same or similar reference numerals represent the same or similar components in the drawings. Thus, each component is described with reference to the drawing in which it first appears, and redundant descriptions related thereto will be omitted unless particularly necessary. In addition, the technique of the present disclosure is not limited to the embodiments described below. That is, the technique of the present disclosure may be modified in various ways without departing from the scope thereof.

### (1) Configuration of Substrate Processing Apparatus

As shown in FIG. 1, a process furnace 202 serving as a processing apparatus (that is, a substrate processing apparatus) according to the present embodiments includes a heater 207 serving as a heating structure (which is a temperature regulator or a temperature adjusting structure). The heater 207 also functions as an activator (also referred to as an "exciter") capable of activating (or exciting) a gas by a heat. A reaction tube 203 is provided in an inner side of the heater 207. A process chamber 201 is provided in a hollow cylindrical portion of the reaction tube 203. The process chamber 201 is configured to be capable of accommodating a plurality of wafers including a wafer 200 serving as a substrate. Hereinafter, the plurality of wafers including the wafer 200 may also be simply referred to as "wafers 200". The wafer 200 is processed in the process chamber 201. Nozzles 249a, 249b and 249c are provided in the process chamber 201 so as to penetrate a lower portion of a side wall of the reaction tube 203. Gas supply pipes 232a, 232b and 232c are connected to the nozzles 249a, 249b and 249c, respectively.

Mass flow controllers (also simply referred to as "MFCs") 241a, 241b and 241c serving as flow rate controllers (flow rate control structures) and valves 243a, 243b and 243c serving as opening/closing valves are sequentially installed at the gas supply pipes 232a, 232b and 232c, respectively, in this order from upstream sides to downstream sides of the gas supply pipes 232a, 232b and 232c in a gas flow direction. A gas supply pipe 232d is connected to the gas supply pipe 232a at a downstream side of the valve 243a of the gas supply pipe 232a. A gas supply pipe 232e is connected to the gas supply pipe 232b at a downstream side of the valve 243b of the gas supply pipe 232b. A gas supply pipe 232f is connected to the gas supply pipe 232c at a downstream side of the valve 243c of the gas supply pipe 232c. MFCs 241d, 241e and 241f and valves 243d, 243e and 243f are sequentially installed at the gas supply pipes 232d, 232e and 232f, respectively, in this order from upstream sides to downstream sides of the gas supply pipes 232d, 232e and 232f in the gas flow direction.

Each of the nozzles 249a, 249b and 249c is installed in an annular space provided between an inner wall of the reaction tube 203 and the wafers 200, and extends upward from a lower portion toward an upper portion of the reaction tube 203 along the inner wall of the reaction tube 203 (that is, extends upward along an arrangement direction of the wafers 200). A plurality of gas supply holes 250a, a plurality of gas supply holes 250b and a plurality of gas supply holes 250c are provided at side surfaces of the nozzles 249a, 249b and 249c, respectively. Gases are supplied via the gas supply holes 250a, the gas supply holes 250b and the gas supply holes 250c, respectively. The gas supply holes 250a, the gas supply holes 250b and the gas supply holes 250c are open toward a center of the reaction tube 203, and are configured such that the gases are supplied toward the wafers 200 via the gas supply holes 250a, the gas supply holes 250b and the gas supply holes 250c, respectively. The gas supply holes 250a, the gas supply holes 250b and the gas supply holes 250c are provided from the lower portion toward the upper portion of the reaction tube 203.

With such a configuration mentioned above, according to the present embodiments, the gases are transferred (supplied), via the nozzles 249a through 249c, into a space defined by the inner wall of the reaction tube 203 and end portions (peripheries) of the wafers 200 arranged in the reaction tube 203. The gases are then supplied toward the wafers 200 in the reaction tube 203 via the gas supply holes 250a opened in the nozzle 249a, the gas supply holes 250b opened in the nozzle 249b and the gas supply holes 250c opened in the nozzle 249c.

An inhibiting agent (hereinafter, also referred to as an "inhibitor") capable of inhibiting an etching of a underlying film by forming a film whose removal rate is lower than that of an etching target (such as a film to be etched) is supplied into the process chamber 201 via the gas supply pipe 232a provided with the MFC 241a and the valve 243a and the nozzle 249a. Hereinafter, the removal rate may also be referred to as an "etching rate".

In the present specification, the term "agent" may contain at least one selected from the group of a gaseous substance and a liquid substance. Further, the liquid substance may contain a mist substance. That is, the inhibiting agent (inhibitor) may contain a gaseous substance, may contain a liquid substance such as a mist substance, or may contain both of the gaseous substance and the liquid substance.

A first halogen element-containing gas (that is, a gas containing a first halogen element) is supplied into the process chamber 201 via the gas supply pipe 232b provided with the MFC 241b and the valve 243b and the nozzle 249b.

A second halogen element-containing gas (that is, a gas containing a second halogen element) is supplied into the process chamber 201 via the gas supply pipe 232c provided with the MFC 241c and the valve 243c and the nozzle 249c.

An inert gas is supplied into the process chamber 201 via the gas supply pipes 232d to 232f provided with the MFCs 241d to 241f and the valves 243d to 243f, respectively, the gas supply pipes 232a to 232c and the nozzles 249a to 249c. For example, the inert gas may act as a purge gas, a carrier gas, a dilution gas and the like.

A first supplier (which is a first supply structure or a first supply system) configured to supply the inhibiting agent (inhibitor) is constituted mainly by the gas supply pipe 232a, the MFC 241a and the valve 243a. The first supplier may also be referred to as an "inhibiting agent supplier" (which is an inhibiting agent supply structure or an inhibiting agent supply system) or an "inhibitor supplier" (which is an inhibitor supply structure or an inhibitor supply system). A second supplier (which is a second supply structure or a second supply system) configured to supply the first halogen element-containing gas is constituted mainly by the gas supply pipe 232b, the MFC 241b and the valve 243b. The second supplier may also be referred to as a "first halogen element-containing gas supplier" (which is a first halogen element-containing gas supply structure or a first halogen element-containing gas supply system). A third supplier (which is a third supply structure or a third supply system) configured to supply the second halogen element-containing gas is constituted mainly by the gas supply pipe 232c, the MFC 241c and the valve 243c. The third supplier may also be referred to as a "second halogen element-containing gas supplier" (which is a second halogen element-containing gas supply structure or a second halogen element-containing gas supply system). Further, an inert gas supplier (which is an inert gas supply structure or an inert gas supply system) configured to supply the inert gas is constituted mainly by the gas supply pipes 232d to 232f, the MFCs 241d to 241f and the valves 243d to 243f.

An exhaust pipe 231 through which the gases in the process chamber 201 are exhausted is connected to the lower portion of the side wall of the reaction tube 203. A vacuum pump 246 serving as a vacuum exhaust apparatus is connected to the exhaust pipe 231 via a pressure sensor 245 and an APC (Automatic Pressure Controller) valve 244. Hereinafter, the vacuum pump 246 may also be simply referred to as a "pump 246". The pressure sensor 245 serves as a pressure detector (pressure detection structure) configured to detect a pressure (inner pressure) of the process chamber 201, and the APC valve 244 serves as a pressure regulator (pressure adjusting structure). With the pump 246 in operation, the APC valve 244 may be opened or closed to perform a vacuum exhaust operation for the process chamber 201 or stop the vacuum exhaust operation. Further, with the pump 246 in operation, the inner pressure of the process chamber 201 may be adjusted by adjusting an opening degree of the APC valve 244 based on pressure information detected by the pressure sensor 245. An exhauster (which is an exhaust structure or an exhaust system) is constituted mainly by the exhaust pipe 231, the pressure sensor 245 and the APC valve 244. The exhauster may further include the pump 246.

A seal cap 219 capable of airtightly sealing (or closing) a lower end opening of the reaction tube 203 is provided under the reaction tube 203. Hereinafter, the seal cap 219 may also be simply referred to as a "cap 219". A rotator (which is a rotating structure) 267 configured to rotate a boat 217 described later is provided under the cap 219. A rotating shaft 255 of the rotator 267 penetrates through the cap 219 such that the rotating shaft 255 is connected to the boat 217. As the rotator 267 rotates the boat 217, the wafers 200 accommodated in the boat 217 are rotated. The cap 219 is elevated or lowered in the vertical direction by a boat elevator 115 serving as an elevating structure provided outside the reaction tube 203. Hereinafter, the boat elevator 115 may also be simply referred to as an "elevator 115". The elevator 115 serves as a transfer device (which is a transfer structure or a transfer system) capable of transferring (loading) the wafers 200 into the process chamber 201 and capable of transferring (unloading) the wafers 200 out of the process chamber 201 by elevating and lowering the cap 219.

The boat 217 serving as a substrate support (or a substrate retainer) is configured such that the wafers 200 (for example, from 25 wafers to 200 wafers) are accommodated (or supported) in the vertical direction in the boat 217 while the wafers 200 are horizontally oriented with their centers aligned with one another in a multistage manner. For example, a plurality of heat insulation plates 218 are supported at a lower portion of the boat 217 while the heat insulation plates 218 are horizontally oriented with their centers aligned with one another in a multistage manner. Further, in the present specification, a notation of a numerical range such as "from 25 wafers to 200 wafers" means that a lower limit and an upper limit are included in the numerical range. Therefore, for example, the numerical range "from 25 wafers to 200 wafers" means a range equal to or higher than 25 wafers and equal to or less than 200 wafers. The same also applies to other numerical ranges described in the present specification.

A temperature sensor 263 serving as a temperature detector is installed in the reaction tube 203. A state of electric conduction to the heater 207 is adjusted based on temperature information detected by the temperature sensor 263 such that a desired temperature distribution of a temperature (inner temperature) of the process chamber 201 can be obtained.

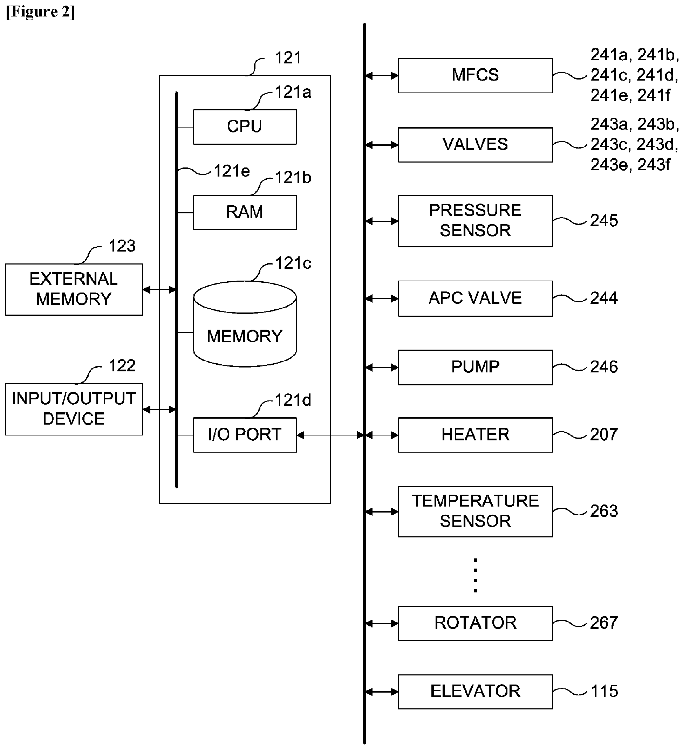

As shown in FIG. 2, a controller 121 serving as a control structure (control apparatus) is constituted by a computer including a CPU (Central Processing Unit) 121a, a RAM (Random Access Memory) 121b, a memory 121c and an I/O port (input/output port) 121d. The RAM 121b, the memory 121c and the I/O port 121d may exchange data with the CPU 121a through an internal bus 121e. For example, an input/output device 122 constituted by a component such as a touch panel is connected to the controller 121. Further, the controller 121 is configured to be capable of being connected to an external memory 123. For example, as the controller 121, the substrate processing apparatus may include a single control structure, or include a plurality of control structures. That is, a control operation of performing a substrate processing described later may be performed using the single control structure, or may be performed using the plurality of control structures. Thus, in the present specification, the term "controller 121" may refer to the single control structure, or may refer to the plurality of control structures.

For example, the memory 121c is configured by a component such as a flash memory and a hard disk drive (HDD). For example, a control program configured to control an operation of the substrate processing apparatus and a process recipe containing information on procedures and conditions of the substrate processing such as an etching process described later may be readably stored in the memory 121c. The process recipe is obtained by combining steps (procedures or processes) of the substrate processing such as the etching process described later such that the controller 121 can execute the steps to acquire a predetermined result, and functions as a program. Hereinafter, the process recipe and the control program may be collectively or individually referred to as a "program". In addition, the process recipe may also be simply referred to as a "recipe". Thus, in the present specification, the term "program" may refer to the recipe alone, may refer to the control program alone or may refer to both of the recipe and the control program. The RAM 121b functions as a memory area (work area) where a program or data read by the CPU 121a is temporarily stored.

The I/O port 121d is connected to the components described above such as the MFCs 241a to 241f, the valves 243a to 243f, the pressure sensor 245, the APC valve 244, the pump 246, the heater 207, the temperature sensor 263, the rotator 267 and the elevator 115.

The CPU 121a is configured to read the control program from the memory 121c and execute the read control program. In addition, the CPU 121a is configured to read the recipe from the memory 121c, for example, in accordance with an operation command inputted from the input/output device 122. In accordance with contents of the read recipe, the CPU 121a may be configured to be capable of controlling various operations such as flow rate adjusting operations for various gases by the MFCs 241a to 241f, opening and closing operations of the valves 243a to 243f, an opening and closing operation of the APC valve 244, a pressure regulating operation (pressure adjusting operation) by the APC valve 244 based on the pressure sensor 245, a start and stop operation of the pump 246, a temperature regulating operation (temperature adjusting operation) by the heater 207 based on the temperature sensor 263, an operation of adjusting a rotation and a rotation speed of the boat 217 by the rotator 267 and an elevating and lowering operation of the boat 217 by the elevator 115.

The controller 121 may be embodied by installing the above-described program stored in the external memory 123 into the computer. For example, the external memory 123 may include a magnetic disk such as the HDD, an optical disk such as a CD, a magneto-optical disk such as an MO and a semiconductor memory such as a USB memory. The memory 121c or the external memory 123 may be embodied by a non-transitory computer readable recording medium. Hereafter, the memory 121c and the external memory 123 may be collectively or individually referred to as a "recording medium". Thus, in the present specification, the term "recording medium" may refer to the memory 121c alone, may refer to the external memory 123 alone, or may refer to both of the memory 121c and the external memory 123. Instead of the external memory 123, a communication interface such as the Internet and a dedicated line may be used for providing the program (program product) to the computer.

### (2) Substrate Processing (Processing Method)

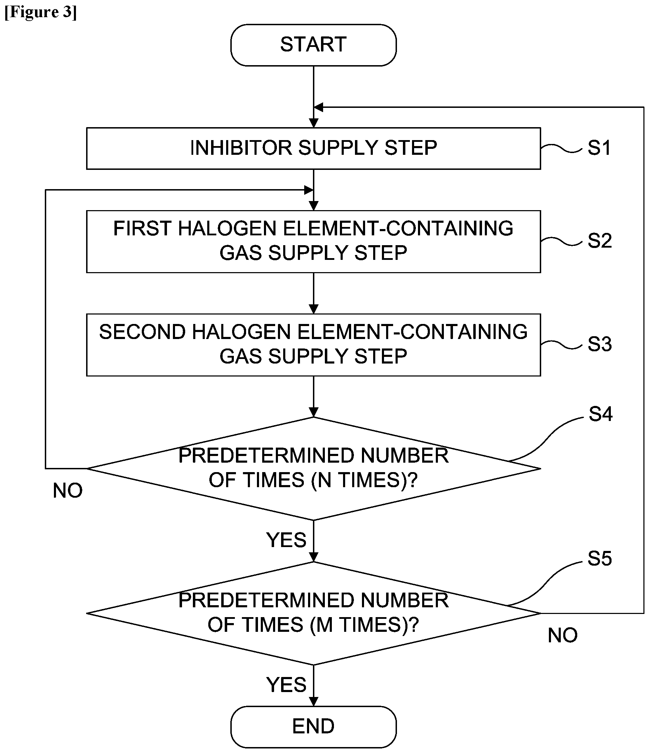

Hereinafter, an example of the etching process of removing (etching) at least a part of a first film 300 of the wafer 200 (where the first film 300 serving as a first surface (first film) and a second film 400 serving as a second surface (second film) are formed on the wafer 200) by using the process furnace 202 described above, which is a part of a manufacturing process of a semiconductor device, will be described mainly with reference to FIGS. 3 to 7. In the following description, the controller 121 is configured to be capable of controlling operations of components constituting the process furnace 202.

For example, the first film 300 (which is the etching target) is an oxygen-containing film (also referred to as an "oxide film"), that is a film containing oxygen (O). As the oxygen-containing film, for example, a film containing a metal element such as aluminum (Al), titanium (Ti), zirconium (Zr), hafnium (Hf), gallium (Ga), indium (In) and zinc (Zn) may be used. Preferably, as the oxygen-containing film, for example, a film containing oxygen and a non-transition metal element such as aluminum, gallium, indium and zinc may be used. As the oxygen-containing film, for example, a film containing two or more of the metal elements exemplified above may be used. In other words, the technique of the present disclosure may be preferably applied when etching a high-dielectric constant film (high-k film) serving as the first film 300 such as an aluminum oxide (Al₂O₃, hereinafter referred to as "AlO") film, a titanium oxide (TiO₂) film, a zirconium oxide (ZrO₂) film and a hafnium oxide (HfO₂) film. Hereinafter, the aluminum oxide film may also be simply referred to as an "AlO film".

For example, the second film 400 (which is not the etching target) is a nitrogen-containing film (also referred to as a "nitride film"), that is, a film containing nitrogen (N). As the nitrogen-containing film, for example, a film containing a metal element such as aluminum, titanium, zirconium, hafnium, gallium, indium and zinc may be used. Preferably, as the nitrogen-containing film, for example, a film containing nitrogen and a transition metal element such as titanium, zirconium and hafnium may be used. As the nitrogen-containing film, for example, a film containing two or more of the metal elements exemplified above may be used. In other words, as the second film 400, for example, a film such as an aluminum nitride (AlN) film, a titanium nitride (TiN) film, a zirconium nitride (ZrN) film and a hafnium nitride (HfN) film may be used. Hereinafter, the titanium nitride film may also be simply referred to as a "TiN film".

As described above, the first film 300 and the second film 400 are formed on the wafer 200, and each of the first film 300 and the second film 400 is made of material removable (etched) by performing steps S2 to S4 of the etching process described later. In addition, the first film 300 and the second film 400 are set so that an etching rate of the first film 300 is lower than an etching rate of the second film 400.

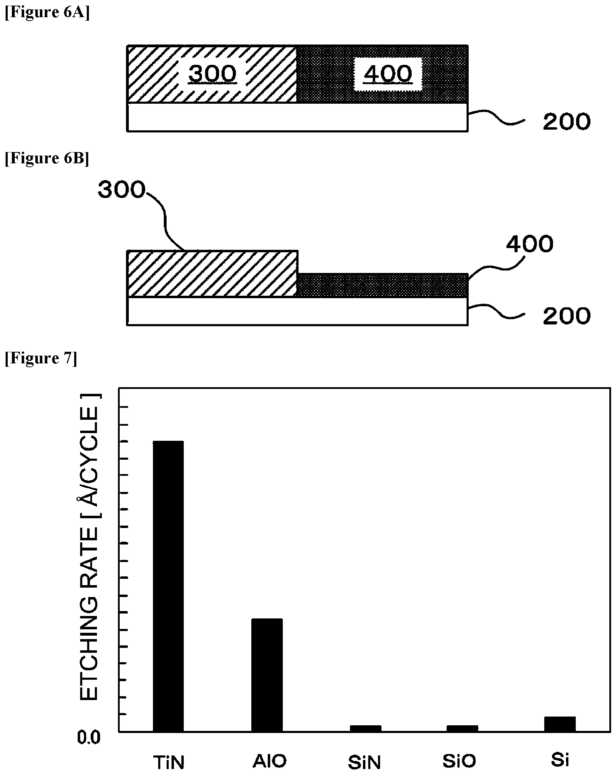

FIGS. 6A and 6B are diagrams schematically illustrating states of the surface of the wafer 200 when the steps S2 to S4 of the etching process described later are performed on the wafer 200 with the first film 300 and the second film 400 formed on the surface thereof. FIG. 7 is a diagram schematically illustrating a comparison of etching rates when the steps S2 to S4 of the etching process described later are performed on the TiN film, the AlO film, a silicon nitride (SiN) film, a silicon oxide (SiO) film and a silicon film. As shown in FIG. 6A, for the wafer 200 with the AlO film (which is an example of the first film 300) and the TiN film (which is an example of the second film 400) formed on the surface thereof, in some cases, it may be desired to etch the AlO film alone without etching the TiN film. However, when the steps S2 to S4 of the etching process are performed on the wafer 200 with the AlO film and the TiN film formed on the surface thereof, the TiN film (which is an example of the second film 400) may be etched more than the AlO film (which is an example of the first film 300) as shown in FIG. 6B. Such a phenomenon occurs since the etching rate of the AlO film is lower than the etching rate of the TiN film, as shown in FIG. 7. In addition, as shown in FIG. 7, the etching rate of the AlO film is higher than that of a silicon-containing film such as the silicon (Si) film, the silicon nitride film and the silicon oxide film.

According to the present embodiments, for example, the silicon-containing film whose etching rate is lower than that of the AlO film is formed on the TiN film whose etching rate is higher than that of the AlO film. Thereby, it is possible to etch the AlO film alone without etching the TiN film. In other words, even when an etching rate of the etching target is lower than that of a film which is not the etching target, it is possible to etch the etching target without etching the film which is not the etching target.

In the present specification, a process sequence of the substrate processing shown in FIG. 3 may be illustrated as follows for convenience. The same also applies to other process sequences described later. [Inhibitor → (First halogen element-containing gas → Second halogen element-containing gas) × N] × M N and M are integers of 1 or more.

In the present specification, the term "wafer" may refer to "a wafer itself", or may refer to "a wafer and a stacked structure (aggregated structure) of a predetermined layer (or layers) or a film (or films) formed on a surface of the wafer". In the present specification, the term "a surface of a wafer" may refer to "a surface of a wafer itself", or may refer to "a surface of a predetermined layer (or a predetermined film) formed on a wafer". Thus, in the present specification, "forming a predetermined layer (or a film) on a wafer" may refer to "forming a predetermined layer (or a film) directly on a surface of a wafer itself", or may refer to "forming a predetermined layer (or a film) on a surface of another layer (or another film) formed on a wafer". In the present specification, the terms "substrate" and "wafer" may be used as substantially the same meaning.

### <Wafer Charging Step>

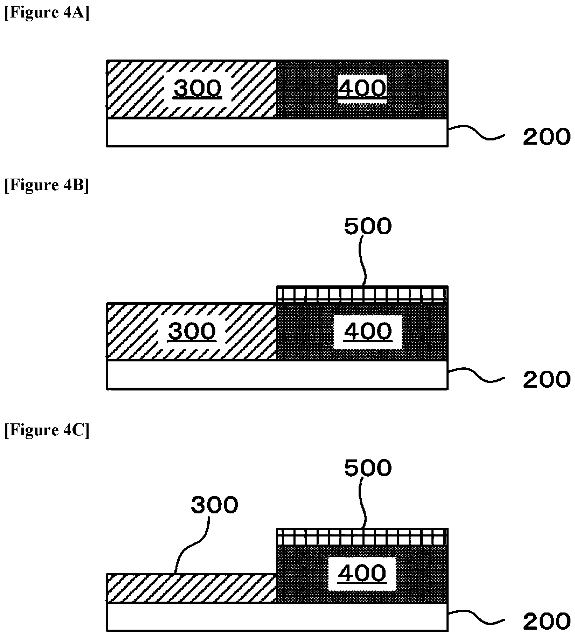

The wafer 200 with the first film 300 and the second film 400 formed on the surface thereof as shown in FIG. 4A is charged (transferred) into the boat 217. Thereafter, the boat 217 supporting the wafers 200 is elevated by the elevator 115 and loaded (transferred) into the process chamber 201.

### <Pressure Adjusting Step and Temperature Adjusting Step>

The pump 246 vacuum-exhausts (decompresses and exhausts) an atmosphere (inner atmosphere) of the process chamber 201 (that is, a space in which the wafers 200 are present (accommodated)) such that the inner pressure of the process chamber 201 reaches and is maintained at a desired process pressure (vacuum degree). In addition, the heater 207 heats the wafer 200 in the process chamber 201 such that a temperature of the wafer 200 in the process chamber 201 reaches and is maintained at a desired process temperature. In addition, a rotation of the wafer 200 is started by the rotator 267. The pump 246 continuously vacuum-exhausts the inner atmosphere of the process chamber 201, the heater 207 continuously heats the wafer 200 in the process chamber 201 and the rotator 267 continuously rotates the wafer 200 until at least a processing of the wafer 200 is completed.

In the present specification, the term "process temperature" may refer to the temperature of the wafer 200 or may refer to the inner temperature of the process chamber 201, and the term "process pressure" may refer to the inner pressure of the process chamber 201. In addition, the term "process time" may refer to a time duration of continuously performing a process related thereto. The same also applies to the following description.

Thereafter, the following steps S1 to S5 are performed on the wafer 200 with the first film 300 and the second film 400 formed on the surface thereof.

### <Inhibitor Supply Step, Step S1>

The valve 243a is opened to supply the inhibitor into the gas supply pipe 232a. After a flow rate of the inhibitor is adjusted by the MFC 241a, the inhibitor whose flow rate is adjusted is supplied into the process chamber 201 through the nozzle 249a, and is exhausted through the exhaust pipe 231. In the present step, the valves 243d to 243f are opened to supply the inert gas into the gas supply pipes 232d to 232f.

After a predetermined time has elapsed from a start of a supply of the inhibitor, the valve 243a is closed to stop the supply of the inhibitor. In the present step, with the APC valve 244 of the exhaust pipe 231 open, the pump 246 vacuum-exhausts the inner atmosphere of the process chamber 201. Thereby, it is possible to remove a residual gas (for example, the inhibitor (which remains unreacted) and reaction by-products remaining on the wafer 200 and/or in the process chamber 201) from the process chamber 201. In the present step, the process chamber 201 may be purged by continuously supplying the inert gas into the process chamber 201 with the valves 243d to 243f open. In such a case, the inert gas acts as the purge gas, which improves an efficiency of removing the residual gas from above the wafer 200.

For example, process conditions of supplying the inhibitor in the present step are as follows:
A process temperature: from 300 °C to 500 °C;
A process pressure: from 0.1 Pa to 3,990 Pa;
A supply time (time duration) of supplying each gas: from 0.01 second to 30 seconds; and
A process partial pressure of the inhibitor: from 0.1 Pa to 3,990 Pa.

Further, the process temperature is set to be substantially the same in each of the steps described later.

In the present specification, the term "supply time" of a certain gas may refer to a time duration of supplying the certain gas onto the wafer 200 or into the process chamber 201. Further, the term "process partial pressure" of the certain gas may refer to a partial pressure of the certain gas in the process chamber 201. The same also applies to the following description.

As the inhibitor, for example, a gas containing a halogen may be used. As the gas containing the halogen, for example, a gas containing chlorine (Cl) may be used. As the gas containing the halogen, a gas further containing a Group 14 element may be used. As the gas containing the halogen and the Group 14 element, for example, a halosilane-based gas such as Si₂Cl₆ gas (abbreviated as HCDS gas) and SiH₂Cl₂ gas (abbreviated as DCS gas) may be used.

In addition, as the inhibitor, for example, a gas containing a Group 14 element may be used. As the gas containing the Group 14 element, for example, a silicon-containing gas containing silicon may be used. As the silicon-containing gas, for example, a silane-based gas such as the HCDS gas, the DCS gas, SiH₄ gas, Si₂H₆ gas and Si₃H₈ gas may be used.

As the inhibitor, one or more of the gases exemplified above may be used.

As the inert gas, for example, in addition to or instead of nitrogen (N₂) gas, a rare gas such as argon (Ar) gas, helium (He) gas, neon (Ne) gas and xenon (Xe) gas may be used. That is, as the inert gas, one or more of the gases exemplified above may be used. The same may also apply to the inert gas supplied in the steps described later.

In the present step, the inhibitor is supplied to the wafer 200 with the first film 300 and the second film 400 formed on the surface thereof. Thereby, at least a part of the inhibitor is adsorbed onto the second film 400 of the wafer 200. That is, as shown in FIG. 4B, an inhibitor film 500 capable of inhibiting an etching of the second film 400 is formed on the second film 400 of the wafer 200. In the present step, the inhibitor film 500 is not formed on the first film 300.

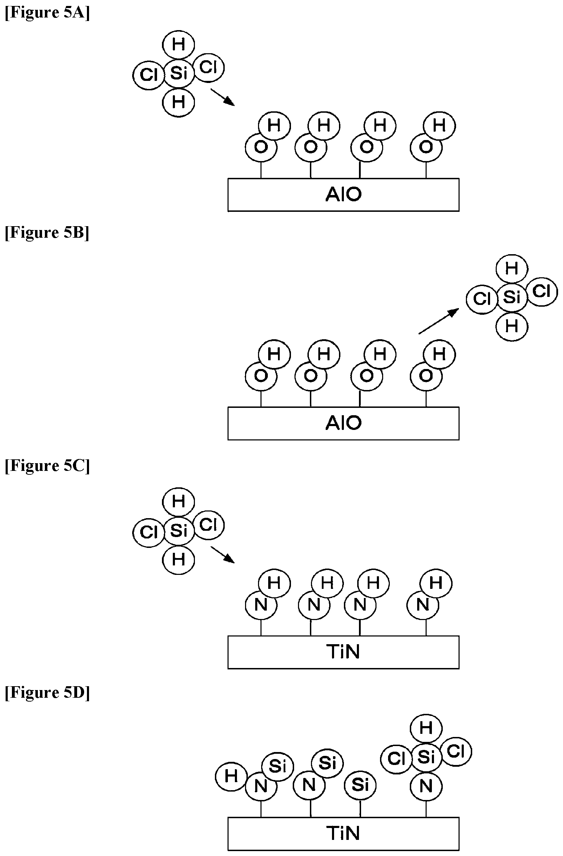

Hereafter, a mechanism of forming the inhibitor film 500 on the second film 400 without forming the inhibitor film 500 on the first film 300 will be described with reference to FIGS. 5A to 5D.

As shown in FIG. 5A, for example, an OH termination (which is formed by Al(CH₃)₃ gas, water vapor (H₂O) (or O₃ gas) and the like) is adsorbed onto a surface of the AlO film (which is an example of the first film 300). As shown in FIG. 5B, for example, when the DCS gas is used as the inhibitor, silicon (which is a Group 14 element contained in the DCS gas) is less likely to react with the OH termination, and silicon is less likely to be adsorbed onto or substituted by the OH termination.

On the other hand, as shown in FIG. 5C, for example, an NH termination (which is formed by TiCl₄ gas, NH₃ gas and the like) is adsorbed onto a surface of the TiN film (which is an example of the second film 400). As shown in FIG. 5D, for example, when the DCS gas is used as the inhibitor, silicon contained in the DCS gas is likely to react with the NH termination, and silicon is likely to be adsorbed onto or substituted by the NH termination.

That is, since the first film 300 contains the OH termination and the second film 400 contains the NH termination, a substance (such as an atom, a molecule and a part of the molecule contained in the inhibitor) is more likely to be adsorbed onto the second film 400 than onto the first film 300. In the present step, at least a part of the inhibitor (for example, the Group 14 element or the molecule containing the Group 14 element) is adsorbed onto or replaced by at least a part of the NH terminations of the second film 400. That is, the NH termination of the second film 400 is replaced by a termination containing the Group 14 element. In addition, the OH termination of the first film 300 is not replaced by the termination containing the Group 14 element. Therefore, the inhibitor film 500 containing the Group 14 element is less likely to be formed on the first film 300, and the inhibitor film 500 containing the Group 14 element is formed on the second film 400.

For example, when the gas containing the halogen and the Group 14 element is used as the inhibitor, by supplying the inhibitor, a group containing the halogen and the Group 14 element contained in the inhibitor can be adsorbed onto the second film 400. Thereby, the inhibitor film 500 containing the Group 14 element such as silicon (that is, the inhibitor film 500 with the Group 14 element such as silicon adsorbed thereon) is formed on the second film 400. That is, the inhibitor film 500 is a film containing the Group 14 element such as silicon. For example, as the inhibitor film 500, the silicon-containing film may be used. As the silicon-containing film, for example, a film such as the silicon film, the silicon nitride film and the silicon oxide film may be used. As described above, the etching rate of the silicon-containing film (which is an example of the inhibitor film 500) such as the silicon film, the silicon nitride film and the silicon oxide film is lower than that of the first film 300.

### <First Halogen Element-containing Gas Supply Step, Step S2>

The valve 243b is opened to supply the first halogen element-containing gas into the gas supply pipe 232b. After a flow rate of the first halogen element-containing gas is adjusted by the MFC 241b, the first halogen element-containing gas whose flow rate is adjusted is supplied into the process chamber 201 through the nozzle 249b, and is exhausted through the exhaust pipe 231. In the present step, the valves 243d to 243f are opened to supply the inert gas into the gas supply pipes 232d to 232f.

After a predetermined time has elapsed from a start of a supply of the first halogen element-containing gas, the valve 243b is closed to stop the supply of the first halogen element-containing gas. In the present step, with the APC valve 244 of the exhaust pipe 231 open, the pump 246 vacuum-exhausts the inner atmosphere of the process chamber 201. Thereby, it is possible to remove a residual gas (for example, the first halogen element-containing gas (which remains unreacted) and reaction by-products remaining on the wafer 200 and/or in the process chamber 201) from the process chamber 201. In the present step, the process chamber 201 may be purged by continuously supplying the inert gas into the process chamber 201 with the valves 243d to 243f open.

For example, process conditions of supplying the first halogen element-containing gas in the present step are as follows:
A process pressure: from 1 Pa to 7,000 Pa;
A supply time (time duration) of supplying each gas: from 10 seconds to 1,000 seconds; and
A process partial pressure of the first halogen element-containing gas: from 10 Pa to 4,000 Pa.

As the first halogen element-containing gas, for example, a gas containing a halogen element such as fluorine (F), chlorine (Cl), Br (bromine) and iodine (I) may be used, and preferably, a fluorine-containing gas (that is, a gas containing fluorine) may be used. As the fluorine-containing gas, for example, at least one among F₂, NF₃, HF, CF₄, WF₆, ClF₃, SF₄, XeF₂ and the like may be used. As the fluorine-containing gas, for example, one or more of the gases exemplified above may be used. In addition, it is preferable that a gas free of the metal element (that is, a gas without containing a metal element) is used as the fluorine-containing gas. In such a case, it is difficult for impurities derived from the fluorine-containing gas to be contained in the film. Thereby, it is possible to improve electrical characteristics of the film. In addition, it is preferable that a gas containing fluorine and an element that does not constitute a film by itself is used as the fluorine-containing gas. As such a gas, for example, a gas such as the F₂, the NF₃, the HF and the XeF₂ may be used. In such a case, it is possible to further reduce an amount of the impurities contained in the film. Thereby, it is possible to suppress a deterioration of the electrical characteristics of the film.

In the present step, by supplying the first halogen element-containing gas to the wafer 200 with the first film 300 (which is the etching target) and the second film 400 (on which the inhibitor film 500 is formed) formed on the surface thereof, a substitution reaction occurs between the first halogen element-containing gas and at least a part of the first film 300. That is, an oxygen atom (O) in the first film 300 reacts with the first halogen element contained in the first halogen element-containing gas so as to be desorbed from the first film 300, and is discharged (exhausted) from the process chamber 201 as the reaction by-products. As a result, as shown in FIGS. 4B and 4C, at least a part of the first film 300 is removed (etched). In addition, in the present step, since the inhibitor film 500 whose etching rate is lower than that of the first film 300 is formed on the second film 400, it is difficult to remove the inhibitor film 500 (that is, it is difficult to remove the second film 400). Specifically, as described above, since the etching rate of the inhibitor film 500 (such as the silicon film, the silicon nitride film and the silicon oxide film) is lower than that of the first film 300 (such as the AlO film), the first film 300 such as the AlO film is etched preferentially (i.e., selectively) as compared with the inhibitor film 500.

### <Second Halogen Element-containing Gas Supply Step, Step S3>

The valve 243c is opened to supply the second halogen element-containing gas into the gas supply pipe 232c. After a flow rate of the second halogen element-containing gas is adjusted by the MFC 241c, the second halogen element-containing gas whose flow rate is adjusted is supplied into the process chamber 201 through the nozzle 249c, and is exhausted through the exhaust pipe 231. In the present step, the valves 243d to 243f are opened to supply the inert gas into the gas supply pipes 232d to 232f.

After a predetermined time has elapsed from a start of a supply of the second halogen element-containing gas, the valve 243c is closed to stop the supply of the second halogen element-containing gas. In the present step, with the APC valve 244 of the exhaust pipe 231 open, the pump 246 vacuum-exhausts the inner atmosphere of the process chamber 201. Thereby, it is possible to remove a residual gas (for example, the second halogen element-containing gas (which remains unreacted) and reaction by-products remaining on the wafer 200 and/or in the process chamber 201) from the process chamber 201. In the present step, the process chamber 201 may be purged by continuously supplying the inert gas into the process chamber 201 with the valves 243d to 243f open.

For example, process conditions of supplying the second halogen element-containing gas in the present step are as follows:
A process pressure: from 10 Pa to 10,000 Pa;
A supply time (time duration) of supplying each gas: from 10 seconds to 1,200 seconds; and
A process partial pressure of the second halogen element-containing gas: from 10 Pa to 5,000 Pa.

As the second halogen element-containing gas, for example, a gas containing a halogen element such as fluorine, chlorine, bromine and iodine may be used, and preferably, a chlorine-containing gas (that is, a gas containing chlorine) may be used. As the chlorine-containing gas, for example, at least one among Cl₂ gas, HCl gas, BCl₃ gas and the like may be used. As the chlorine-containing gas, for example, one or more of the gases exemplified above may be used. In addition, it is preferable that a gas free of the metal element is used as the chlorine-containing gas. In such a case, it is difficult for impurities derived from the chlorine-containing gas to be contained in the film. Thereby, it is possible to improve the electrical characteristics of the film.

In the present step, by supplying the second halogen element-containing gas to the wafer 200 with the first film 300 (which is the etching target) and the second film 400 (on which the inhibitor film 500 is formed) formed on the surface thereof, a substitution reaction occurs between the second halogen element-containing gas and at least a part of the first film 300. That is, an oxygen atom (O) in the first film 300 reacts with the second halogen element contained in the second halogen element-containing gas so as to be desorbed from the first film 300, and is discharged (exhausted) from the process chamber 201 as the reaction by-products. As a result, at least a part of the first film 300 is removed (etched). In addition, in the present step, similar to the step S2, since the inhibitor film 500 whose etching rate is lower than that of the first film 300 is formed on the second film 400, it is difficult to remove the inhibitor film 500 (that is, it is difficult to remove the second film 400).

### <Performing Predetermined Number of Times, Step S4>

By performing a first cycle (in which the step S2 and the step S3 described above are sequentially performed in this order) a predetermined number of times (N times, where N is an integer of 1 or more), at least a part of the first film 300 (which is the etching target) is removed.

### <Performing Predetermined Number of Times, Step S5>

Then, after performing the first cycle (in which the step S2 and the step S3 described above are sequentially performed in this order) the predetermined number of times (N times, where N is an integer of 1 or more), the process returns to a process of the step S1 described above, and a second cycle (in which the step S1 to the step S4 described above are sequentially performed in this order) is performed a predetermined number of times (M times, where M is an integer of 1 or more). Thereby, at least a part of the first film 300 (which is the etching target) is removed until a predetermined thickness (also referred to as a "depth") of the first film 300 is obtained.

Even when the inhibitor film 500 on the second film 400 is etched (partially etched) by performing the steps S2 and S3 the predetermined number of times (N times), it is possible to form the inhibitor film 500 on the second film 400 again in a manner described above before an entirety of the inhibitor film 500 on the second film 400 is etched. Thereby, it is possible to selectively etch the first film 300 until the predetermined thickness of the first film 300 is obtained.

### <After-purge Step and Returning to Atmospheric Pressure Step>

The inert gas is supplied into the process chamber 201 through each of the gas supply pipes 232d to 232f, and then is exhausted through the exhaust pipe 231. Thereby, the process chamber 201 is purged with the inert gas. As a result, a substance such as the residual gas remaining in the process chamber 201 and the reaction by-product remaining in the process chamber 201 can be removed from the process chamber 201. Thereafter, the inner atmosphere of the process chamber 201 is replaced with the inert gas, and the inner pressure of the process chamber 201 is returned to the normal pressure (atmospheric pressure).

### <Wafer Discharging Step>

Thereafter, the cap 219 is lowered by the elevator 115 and the lower end opening of the reaction tube 203 is opened. Then, the boat 217 with the wafers 200 (which are processed and supported in the boat 217) is unloaded (transferred) out of the reaction tube 203 through the lower end opening of the reaction tube 203. Then, the wafers 200 (which are processed) are discharged (transferred) from the boat 217.

### (3) Effects according to Present Embodiments

According to the present embodiments, it is possible to obtain one or more of the following effects.
(a) By supplying the inhibitor, it is possible to form the inhibitor film 500 (which is capable of inhibiting the etching of the second film 400) on the second film 400 alone without forming the inhibitor film 500 on the first film 300.
(b) It is possible to selectively etch the first film 300 (on which the inhibitor film 500 is not formed) on the wafer 200 with the first film 300 and the second film 400 formed on the surface thereof.

### (4) Other Embodiments

While the technique of the present disclosure is described in detail by way of the embodiments mentioned above, the technique of the present disclosure is not limited thereto. For example, the technique of the present disclosure may be modified in various ways without departing from the scope thereof. In the following modified example, portions (features) different from that of the embodiments mentioned above will be described in detail.

### <Modified Example>

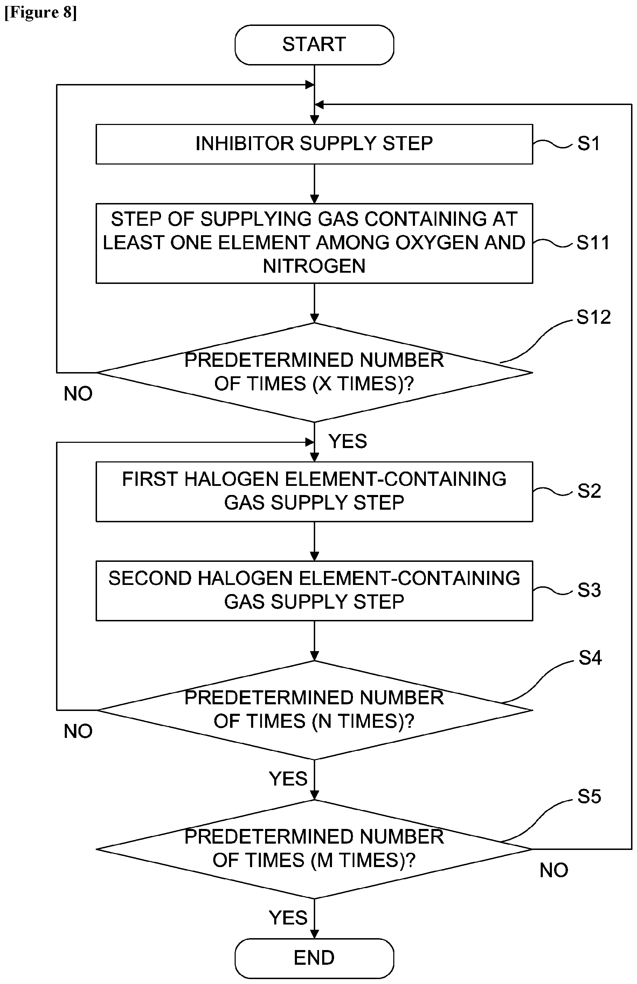

As shown in FIG. 8, according to the present modified example, between the inhibitor supply step (step S1) and the first halogen element-containing gas supply step (step S2) in the substrate processing mentioned above, a step (that is, a step S11) of supplying a gas containing at least one element among oxygen and nitrogen is performed. In addition, a step (that is, a step S12) of performing the step S1 and the step S11 a predetermined number of times (X times, where X is an integer of 1 or more) is performed. That is, according to the present modified example, a gas supplier configured to supply the gas containing at least one element among oxygen and nitrogen is provided in the process furnace 202 mentioned above. In addition, by supplying the inhibitor and the gas containing at least one element among oxygen and nitrogen the predetermined number of times (X times) before performing the first halogen element-containing gas supply step (step S2), it is possible to form the inhibitor film 500 on the second film 400. In other words, as an inhibitor film forming step of forming the inhibitor film 500, the inhibitor supply step (step S1), the step (step S11) of supplying the gas containing at least one element among oxygen and nitrogen and the step (step S12) of performing the step S1 and the step S11 the predetermined number of times (X times, where X is an integer of 1 or more) are performed. A process sequence of the substrate processing according to the present modified example may be illustrated as follows for convenience. [(Inhibitor → Gas containing at least one element among O and N) × X → (First halogen element-containing gas → Second halogen element-containing gas) × N] × M X, N and M are integers of 1 or more.

According to the present modified example, as the inhibitor film 500, a film (serving as a Group 14 element-containing film and containing the Group 14 element and at least one element among oxygen and nitrogen) is formed. That is, as the inhibitor film 500, a compound containing silicon (such as the silicon oxide film, the silicon nitride film and a silicon oxynitride (SiON) film) whose etching rate is lower than that of the first film 300 is formed on the second film 400. According to the present modified example, it is possible to obtain substantially the same effects as in the embodiments mentioned above.

In addition, the present modified example is not limited to such a case where the inhibitor supply step (step S1), the step (step S11) of supplying the gas containing at least one element among oxygen and nitrogen and the step (step S12) of performing the step S1 and the step S11 the predetermined number of times (X times) are performed. For example, the inhibitor supply step (step S1) and the step (step S11) of supplying the gas containing at least one element among oxygen and nitrogen may be performed simultaneously. That is, the inhibitor and the gas containing at least one element among oxygen and nitrogen may be supplied simultaneously. Even in such a case, it is possible to obtain substantially the same effects as in the embodiments mentioned above.

In addition, the embodiments mentioned above are described by way of an example in which the etching target is the film formed on the wafer 200. However, the technique of the present disclosure is not limited thereto. For example, the technique of the present disclosure may be preferably applied even when the etching target is a film formed on an inner wall of the process chamber 201 or on surfaces of walls or components inside the reaction tube 203 (such as the boat 217, the nozzles 249a to 249c and the cap 219). In addition, for example, the technique of the present disclosure may be preferably applied even when a process of forming the film on the wafer 200 is performed in the process chamber 201 and the film is etched in the process chamber 201. Even in such a case, it is possible to obtain substantially the same effects as in the embodiments mentioned above.

In addition, in the embodiments mentioned above, the first halogen element used in the first halogen element-containing gas supply step (step S2) and the second halogen element used in the second halogen element-containing gas supply step (step S3) may be the same halogen element, or may be different halogen elements. In addition, the first halogen element-containing gas used in the first halogen element-containing gas supply step (step S2) and the second halogen element-containing gas used in the second halogen element-containing gas supply step (step S3) may be the same gas, or may be different gases. Even in such a case, it is possible to obtain substantially the same effects as in the embodiments mentioned above. When the same gas (that is, a gas with the same molecular structure) is used as the first halogen element-containing gas and the second halogen element-containing gas, it is possible to simplify the gas supplier and process procedures.

It is preferable that the recipe used to perform the substrate processing is prepared individually in accordance with the contents of the substrate processing, and a plurality of recipes are stored (installed) in the memory 121c in advance via an electric communication line or the external memory 123. Then, when starting the substrate processing, the CPU 121a preferably selects an appropriate recipe among the recipes stored in the memory 121c in accordance with the contents of the substrate processing. With such a configuration, various films of different types, different composition ratios, different qualities and different thicknesses can be formed with a high reproducibility using a single substrate processing apparatus. In addition, since a burden on an operator can be reduced, various processes (that is, the substrate processing) can be performed quickly while avoiding a misoperation of the substrate processing apparatus.

The recipe mentioned above is not limited to creating a new recipe. For example, the recipe may be prepared by changing an existing recipe stored in the substrate processing apparatus in advance. When changing the existing recipe to a new recipe, the new recipe may be installed in the substrate processing apparatus via the electric communication line or the recording medium in which the new recipe is stored. For example, the existing recipe already stored in the substrate processing apparatus may be directly changed to the new recipe by operating the input/output device 122 of the substrate processing apparatus.

For example, the embodiments mentioned above are described by way of an example in which a batch type substrate processing apparatus capable of simultaneously processing a plurality of substrates is used. However, the technique of the present disclosure is not limited thereto. For example, the technique of the present disclosure may be preferably applied when a single wafer type substrate processing apparatus capable of processing one or several substrates at once is used. For example, the embodiments mentioned above are described by way of an example in which a substrate processing apparatus including a hot wall type process furnace is used. However, the technique of the present disclosure is not limited thereto. For example, the technique of the present disclosure may be preferably applied when a substrate processing apparatus including a cold wall type process furnace is used.

The invention may be summarized as follows: It is possible to possible to selectively etch a specific region. There is provided a technique that includes: (a) adsorbing an inhibitor onto a second surface of an object by supplying the inhibitor to the object, wherein the object is provided with a first surface and the second surface; (b) supplying a first halogen element-containing gas to the first surface; (c) supplying a second halogen element-containing gas to the first surface; and (d) removing at least a part of the first surface by performing (b) and (c) N times.

The process procedures and the process conditions of each process using the substrate processing apparatuses exemplified above may be substantially the same as those of the embodiments or the modified example mentioned above. Even in such a case, it is possible to obtain substantially the same effects as in the embodiments or the modified example mentioned above.

For example, the embodiments and the modified example mentioned above may be appropriately combined with each other. The process procedures and the process conditions of each combination thereof may be substantially the same as those of the embodiments or the modified example mentioned above.

### [Description of Reference Numerals]

- 00: first film (first surface)
- 400: second film (second surface)

## Claims

1. A processing method comprising:
(a) adsorbing an inhibitor onto a second surface of an object by supplying the inhibitor to the object, wherein the object is provided with a first surface and the second surface;
(b) supplying a first halogen element-containing gas to the first surface;
(c) supplying a second halogen element-containing gas to the first surface; and
(d) removing at least a part of the first surface by performing (b) and (c) N times.

2. The processing method of claim 1, further comprising
(e) removing at least a part of the first surface by performing (a) and (d) M times.

3. The processing method of any one or more of claims 1 to 2, wherein each of the first surface and the second surface is made of a material removable by performing (b) and (c).

4. The processing method of any one or more of claims 1 to 3, wherein the first surface and the second surface are set so that a removal rate of the first surface is lower than a removal rate of the second surface.

5. The processing method of any one or more of claims 1 to 4, wherein the first surface contains oxygen and the second surface contains nitrogen.

6. The processing method of any one or more of claims 1 to 5, wherein the first surface contains a non-transition metal element, and the second surface contains a transition metal element.

7. The processing method of any one or more of claims 1 to 6, wherein the first surface contains an OH termination, and the second surface contains an NH termination.

8. The processing method of claim 7, wherein the inhibitor contains a Group 14 element, and
wherein, in (a), at least a part of the NH termination is replaced by a termination containing the Group 14 element, and the OH termination is not replaced by the termination containing the Group 14 element.

9. The processing method of claim any one or more of claims 1 to 8, wherein, in (a), a gas containing at least one element among oxygen and nitrogen is further supplied.

10. The processing method of any one or more of claims 1 to 9, wherein, in (a), the inhibitor and the gas containing at least one element among oxygen and nitrogen are supplied a predetermined number of times.

11. The processing method of any one or more of claims 1 to 10, wherein the inhibitor contains a halogen.

12. The processing method of claim 11, wherein the inhibitor further contains a Group 14 element, and
wherein, in (a), a group containing the halogen and the Group 14 element contained in the inhibitor is adsorbed onto the second surface.

13. A method of manufacturing a semiconductor device, comprising: the processing method of any one or more of claims 1 to 12.

14. A program that causes a processing apparatus, by a computer, to perform:
(a) adsorbing an inhibitor onto a second surface of an object by supplying the inhibitor to the object, wherein the object is provided with a first surface and the second surface;
(b) supplying a first halogen element-containing gas to the first surface;
(c) supplying a second halogen element-containing gas to the first surface; and
(d) removing at least a part of the first surface by performing (b) and (c) N times.

15. A processing apparatus comprising:
a first supplier configured to supply an inhibitor to an object, wherein the object is provided with a first surface and a second surface;
a second supplier configured to supply a first halogen element-containing gas to the first surface;
a third supplier configured to supply a second halogen element-containing gas to the first surface; and
a controller configured to be capable of controlling the first supplier, the second supplier and the third supplier to perform:
(a) adsorbing the inhibitor onto the second surface by supplying the inhibitor to the object;
(b) supplying the first halogen element-containing gas to the first surface;
(c) supplying the second halogen element-containing gas to the first surface; and
(d) removing at least a part of the first surface by performing (b) and (c) N times.
